# EUROPEAN PATENT APPLICATION

(11) **EP 2 184 800 A1**
(43) Date of publication of application: **12.05.2010**
(21) Application number: 08790253.2
(22) Date of filing: 23.07.2008
(51) Int. Cl.: H01M 10/48, G01R 31/36, H01M 2/16, H01M 4/02, H01M 10/42

(54) **CELL INTERNAL SHORTCIRCUIT DETECTION DEVICE, METHOD, BATTERY PACK, AND ELECTRONIC DEVICE SYSTEM**

(30) Priority: 26.07.2007 JP 2007194813; 18.07.2008 JP 2008187283
(71) Applicant: Panasonic Corporation, Kadoma-shi Osaka 571-8501 (JP)
(72) Inventor: ASAKURA Jun c/o Panasonic Corporation, Chuo-ku Osaka-shi Osaka (JP); NAKASHIMA Takuya c/o Panasonic Corporation, Chuo-ku Osaka-shi Osaka (JP); NAKATSUJI Toshiyuki c/o Panasonic Corporation, Chuo-ku Osaka-shi Osaka (JP); FUJIKAWA Masato c/o Panasonic Corporation, Chuo-ku Osaka-shi Osaka (JP)
(74) Representative: Schwabe - Sandmair - Marx
(86) International application number: PCT/JP2008/001964
(87) International publication number: WO 2009/013899

(57) **Abstract**

A battery internal short-circuit detecting device has: a battery temperature detection unit for detecting a battery temperature Tr; an ambient temperature detection unit for detecting an ambient temperature Te; an average heating value detection unit for detecting an average value Pav of battery heating values per predetermined first period ΔW1, which are generated by discharging or charging the battery; a battery temperature estimation unit for obtaining a battery temperature Tp estimated to be reached after a lapse of a predetermined second period ΔW2 since the detection of the average value Pav of the heating values, based on the average value Pav of the heating values and the ambient temperature Te; and an internal short-circuit determination unit for determining that an internal short circuit has occurred when the actual battery temperature Tr after the lapse of the second period ΔW2 is equal to or greater than the sum of the estimated battery temperature Tp and a predetermined coefficient α.

## Description

### Technical Field

The present invention relates to a device, a method, a battery pack and an electronic device system for detecting an internal short circuit of a nonaqueous electrolyte secondary battery, such as a nonaqueous electrolyte secondary battery that has, between its negative electrode and positive electrode, a heat-resistant layer composed of a porous protective film or the like having a resin binder and an inorganic oxide filler, or a nonaqueous electrolyte olivine-type lithium iron phosphate secondary battery with an electrode plate resistance of at least 4 Ω·cm².

### Background Art

Patent Document 1 and Patent Document 2, for example, describe a nonaqueous electrolyte secondary battery that has, between its negative electrode and positive electrode, a porous protective film with a resin binder and inorganic oxide filler. According to the structure of the nonaqueous electrolyte secondary battery with a porous protective film, even if active materials that fall off the electrodes or chips generated during a cutting process adhere to the surfaces of the electrodes at the time of manufacturing, an internal short circuit is prevented from occurring thereafter. However, due to this structure, a conventional method that is used in a conventionally-structured cell with no porous protective film has a problem of not being able to detect the occurrence of an internal short circuit even when the internal short circuit occurs.

In order to explain this problem, the conventional method that is used in the conventionally-structured cell with no porous protective film is described below first.

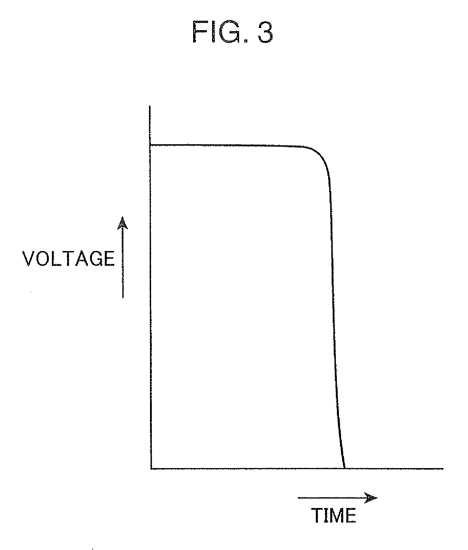

Specifically, when an internal short circuit occurs in the conventionally-structured cell with no porous protective film, the voltage of the cell drops rapidly, as shown in Fig. 3, and does not return thereafter. Therefore, the internal short circuit can be detected by either monitoring the voltage of the cell with an appropriate period or detecting a drastic temperature increase caused by a short circuit current.

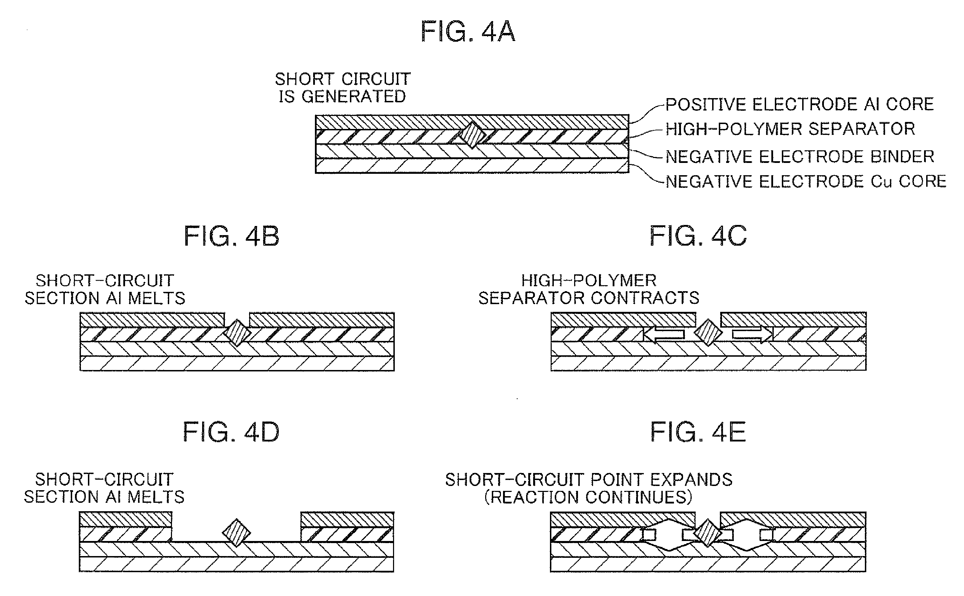

The following mechanisms explain the fact mentioned above. For example, when an internal short circuit shown in Fig. 4A is caused by a metallic foreign matter such as an electrode material or chip that falls off during the manufacturing process, the heat generated by the short circuit melts a positive-electrode aluminum core in a short-circuit part, as shown in Fig. 4B. Subsequently, the heat generated from this melting melts and contracts a separator made of polyethylene or other high-polymer material, as shown in Fig. 4C, and a short circuit hole expands, as shown in Fig. 4D, whereby the short circuit area increases. Thereafter, the short-circuit section melts, as shown in Fig. 4E, and the resultant heat repeats the expansion of the melting (short circuit hole) again as shown in Fig. 4C. In this manner, the voltage of the cell drops rapidly, and the drastic increase of the temperature of the cell is caused by the thermal runaway.

Patent Document 3, for example, discloses that an internal short circuit or the like can be detected at the time of non-operation, by storing the increase of the temperature caused by the internal short circuit or the like. Patent Document 3 also discloses that when a significant temperature increase is detected in relation to a significant voltage decrease, it is determined that an internal short circuit has occurred. Furthermore, Patent Document 4 discloses that an internal short circuit is detected from a voltage, pressure, temperature, sound, and the like. In addition, Patent Document 5 discloses that a signal with a plurality of frequencies is applied from an electrode to detect an internal short circuit.

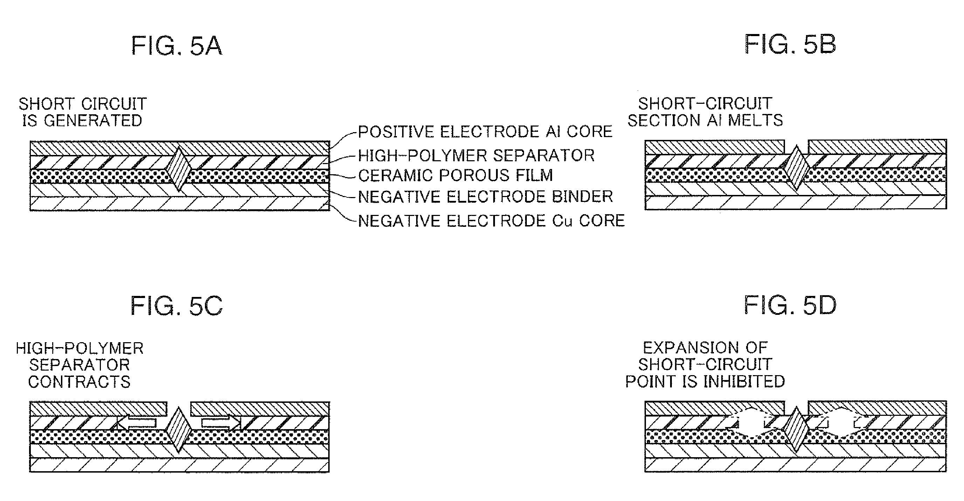

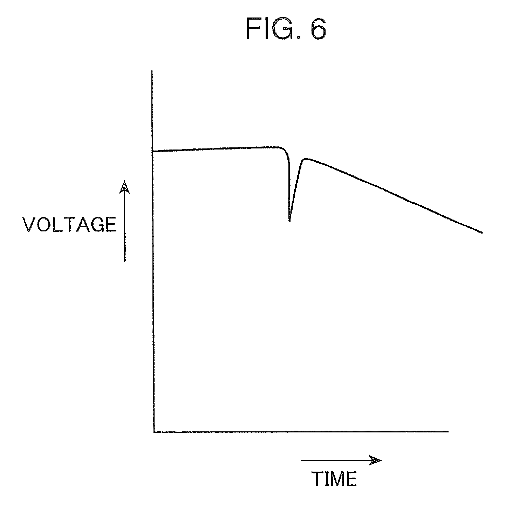

On the other hand, in the structure having the porous protective film as described in Patent Document 1 or Patent Document 2, when an internal short circuit occurs by the metallic foreign matter such as an electrode material or chip that falls off during the manufacturing process, as shown in Fig. 5A, the following takes place. In other words, even when the positive-electrode aluminum core of the short-circuit part melts as shown in Fig. 5B, the porous protective film prevents the positive-electrode aluminum core from coming into contact with a negative-electrode mixture. Therefore, as shown in Fig. 5B to Fig. 5D, the separator melts only in the vicinity of a region where the metallic foreign matter exists, whereby the expansion of the short circuit is inhibited. Thereafter, the voltage of the cell is nearly returned and can be used when there is a micro short circuit. Fig. 6 shows the changes of the voltage of the cell that occur upon generation of an internal short circuit in the structures described in Patent Document 1 and Patent Document 2. Therefore, it is difficult to detect an internal short circuit by using the methods described in Patent Documents 3 to 5.

Moreover, a secondary battery using olivine-type lithium iron phosphate (LiFePO₄) as a positive-electrode material has high thermal/chemical stability and is so inexpensive that it is expected to be used as an alternative to a secondary battery that uses lithium cobaltate. However, because the secondary battery using olivine-type lithium iron phosphate (LiFePO₄) as the positive-electrode material has a low conductivity and the diffusion rate of lithium ion is extremely low, this secondary battery has the same problem of not being able to detect an internal short circuit by using the methods described in Patent Documents 3 to 5, as in the secondary batteries of Patent Document 1 and Patent Document 2 that are structured to have the porous protective film.
Patent Document 1: Japanese Patent Application No. 3371301
Patent Document 2: WO 05/098997
Patent Document 3: Japanese Patent Application Laid-open No. H8-83630
Patent Document 4: Japanese Patent Application Laid-open No. 2002-8631
Patent Document 5: Japanese Patent Application Laid-open No. 2003-317810

### Disclosure of the Invention

An object of the present invention is to provide a battery internal short-circuit detecting device, a method, a battery pack and an electronic device system capable of reliably detecting an internal short circuit in a battery whose voltage does not drop rapidly even when an internal short circuit is generated.

In order to achieve the foregoing object of the present invention, a battery internal short-circuit detecting device according to one aspect of the present invention has: a battery temperature detection unit for detecting a battery temperature Tr; an ambient temperature detection unit for detecting an ambient temperature Te; an average heating value detection unit for detecting an average value Pav of battery heating values per predetermined first period ΔW1, which are generated by discharging or charging the battery; a battery temperature estimation unit for obtaining a battery temperature Tp estimated to be reached after a lapse of a predetermined second period ΔW2 since the detection of the average value Pav of the heating values, based on the average value Pav of the heating values and the ambient temperature Te; and an internal short-circuit determination unit for determining that an internal short circuit has occurred when an actual battery temperature Tr after the lapse of the second period ΔW2 is equal to or greater than the sum of the estimated battery temperature Tp and a predetermined coefficient α.

In order to achieve the foregoing object of the present invention, a battery internal short-circuit detecting method according to another aspect of the present invention has: an average heating value detection step of detecting an average value Pav of battery heating values per predetermined first period ΔW1, which are generated by discharging or charging a battery; a battery temperature estimation step of obtaining a battery temperature Tp estimated to be reached after a lapse of a predetermined second period ΔW2 since the detection of the average value Pav of the heating values, based on the average value Pav of the heating values and the ambient temperature Te; a step of detecting an actual battery temperature Tr after the lapse of the second period ΔW2; and an internal short-circuit determination step of determining that an internal short circuit has occurred when the actual battery temperature Tr after the lapse of the second period ΔW2 is equal to or greater than the sum of the estimated battery temperature Tp and a predetermined coefficient α.

According to the foregoign configuration, an internal short circuit can be detected reliably even in a battery whose voltage does not drop rapidly even when an internal short is generated, as will be described hereinafter.

In other words, when the temperature of the battery does not increase proportionately to the amount of charge or discharge, it is speculated that an internal short circuit is generated by the above mentioned mechanisms and that a discharging current flows through the short-circuit section in the battery. Thus, whether an internal short circuit has occurred or not is determined by detecting the flow of the discharging current.

Specifically, the battery is discharged or charged for the predetermined first period ΔW1, and the average heating value detection unit detects the average value Pav of the heating values of the first period ΔW1. Moreover, the ambient temperature detection unit detects the ambient temperature Te for deciding the radiation property of the heat generated in the battery, when or after the first period ΔW1 elapses. Then, the battery temperature estimation unit obtains the battery temperature Tp that is estimated to be reached after a lapse of the predetermined second period ΔW2 since the detection of the average value Pav of the heating values, based on the average value Pav of the heating values and the ambient temperature Te. Further, the internal short-circuit determination unit determines that an internal short circuit has occurred, when the actual battery temperature Tr after the lapse of the second period ΔW2 is equal to or greater than the sum of the estimated battery temperature Tp and the coefficient α.

As a result, an internal short circuit can be detected with a high degree of accuracy, even in a battery whose voltage does not drop drastically even when an internal short circuit is generated.

A battery pack according to yet another aspect of the present invention has a battery and the battery internal short-circuit detecting device of the present invention.

An electronic device system according to yet another aspect of the present invention has a battery, a loading device supplied with power from the battery, and the battery internal short-circuit detecting device of the present invention.

According to the battery pack and the electronic device system of the present invention, the same effects as achieved from the configuration of each of the internal short-circuit detecting devices of the present invention described above can be accomplished.

The object, characteristics and advantages of the present invention will be more clearly understood through the following detailed description and the accompanied drawings.

### Brief Description of the Drawings

[Fig. 1] Fig. 1 is a block diagram showing an electrical configuration of an electronic device system, which is an internal short-circuit detecting device of a nonaqueous electrolyte secondary battery according to an embodiment of the present invention.
[Fig. 2] Fig. 2 is a flowchart which explains in detail an internal short-circuit determination operation according to an embodiment of the present invention.
[Fig. 3] Fig. 3 is a graph showing changes in voltage at the time of the occurrence of an internal short circuit in a conventionally-structured secondary battery cell.
[Fig. 4] Figs. 4A to 4E are schematic cross-sectional diagrams which illustrate a phenomenon of an internal short-circuit section in the conventionally-structured secondary battery cell.
[Fig. 5] Figs. 5A to 5D are schematic cross-sectional diagrams which illustrate a phenomenon of an internal short-circuit section in a nonaqueous electrolyte secondary battery that has, between its negative electrode and positive electrode, a heat-resistant layer composed of a porous protective film having a resin binder and an inorganic oxide filler.
[Fig. 6] Fig. 6 is a graph for showing changes in voltage at the time of the occurrence of an internal short circuit in the nonaqueous electrolyte secondary battery cell that has, between its negative electrode and positive electrode, a heat-resistant layer composed of a porous protective film having a resin binder and an inorganic oxide filler.
[Fig. 7] Fig. 7 is a functional block diagram of a battery internal short-circuit detecting device according to an embodiment of the present invention.

### Best Mode for Carrying Out the Invention

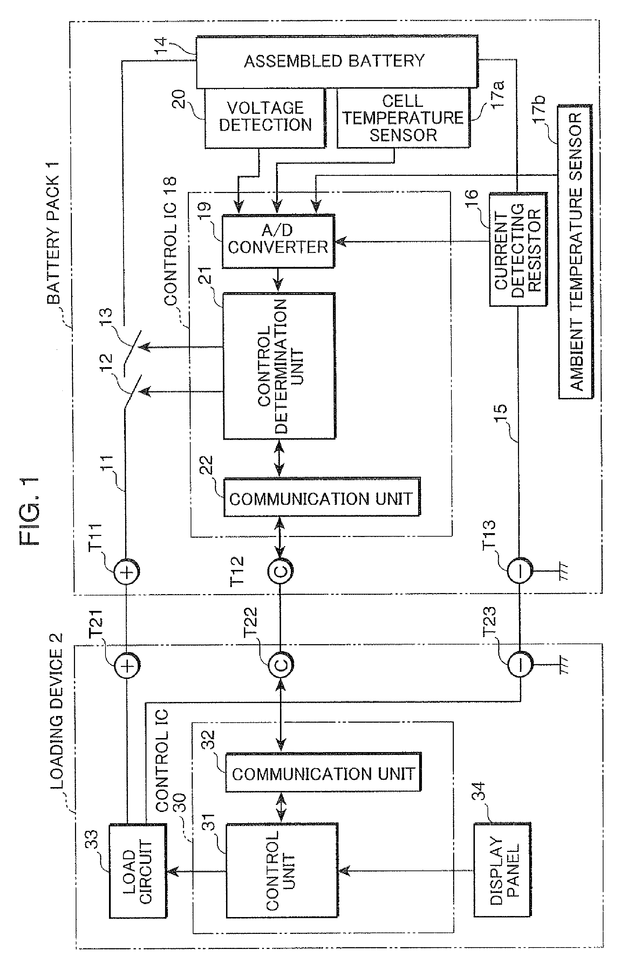

Fig. 1 is a block diagram showing an electrical configuration of an electronic device system that has an internal short-circuit detecting device of a nonaqueous electrolyte secondary battery according to an embodiment of the present invention. This electronic device system is configured by providing a battery pack 1 with a loading device 2 that is supplied with power from the battery pack 1, but the battery pack 1 is charged by an unshown charger. When charging the battery pack 1, the battery pack 1 may be attached to the loading device 2 and charged via the loading device 2. The battery pack 1 and the loading device 2 are interconnected with each other by DC high-side terminals T11, T21 for power supply, terminals T12, T22 for communication signals, and GND terminals T13, T23 for power supply and communication signals. The same three types of terminals are provided to the charger as well.

In the battery pack 1, charging and discharging FETs 12, 13 of different conductive types are interposed in a charging/discharging path 11 on the DC high side that extends from the terminal T11, and this charging/discharging path 11 is connected to a high-side terminal of an assembled battery (secondary battery, battery) 14. A low-side terminal of the assembled battery 14 is connected to the GND terminal T13 via a charging/discharging path 15 on the DC low side, and a current detecting resistor 16 for converting a charging current and a discharging current into a voltage value is interposed in this charging/discharging path 15.

The assembled battery 14 is configured by connecting a plurality of cells in series or in parallel or by combining the serial and parallel connections thereof. The temperature of the cells is detected by a cell temperature sensor (battery temperature detection unit) 17a and input to an analog/digital converter 19 within a control IC 18. The ambient temperature is detected by an ambient temperature sensor (ambient temperature detection unit) 17b and similarly input to the analog/digital converter 19 within the control IC 18. The voltage between terminals of each cell is read by a voltage detection circuit (terminal voltage detection unit) 20 and input to the analog/digital converter 19 within the control IC 18. Furthermore, a current value detected by the current detecting resistor (current detection unit) 16 is also input to the analog/digital converter 19 within the control IC 18. The analog/digital converter 19 converts each input value into a digital value and outputs the digital value to a control determination unit 21.

The control determination unit 21 has a microcomputer, a peripheral circuit thereof, and the like. In response to each input value from the analog/digital converter 19, this control determination unit 21 calculates the percentage of the state of charge of the assembled battery 14 in relation to when the assembled battery 14 is fully charged, and transmits the calculated percentage from a communication unit 22 to the loading device 2 via the terminals T12, T22; T13, T23. Based on each input value from the analog/digital converter 19, the control determination unit 21 also calculates a voltage value and current value of a charging current that are required to be output by the charger, and transmits the calculated voltage value and current value from the communication unit 22 via the terminal T12. Furthermore, from each input value, the control determination unit 21 detects an abnormality on the outside of the battery pack 1, such as a short circuit between the terminals T11, T13 or an abnormal current from the charger, and also detects an abnormality such as the occurrence of an internal short circuit in the assembled battery 14. Then, when these abnormalities are detected, the control determination unit 21 blocks the FETs 12, 13 or performs other protective operation.

In the loading device 2, the state of charge of the assembled battery 14 is received by a communication unit 32 of a control IC 30, and the control unit 31 calculates a remaining usage time of the battery pack I based on the power consumption of various load circuits 33 and displays the result on a display panel 34. The control unit 31 also controls the various load circuits 33 in response to an input from an unshown input operation device.

In the battery pack 1 configured above, the assembled battery 14 of the present embodiment is configured by a nonaqueous electrolyte secondary battery that has, between its negative electrode and positive electrode, a heat-resistant layer (porous protective film) as shown in Fig. 5, or a nonaqueous electrolyte olivine-type lithium iron phosphate secondary battery with an electrode plate resistance of at least 4 Ω·cm², It should be noted that the control determination unit 21 determines whether or not an internal short circuit is generated in the assembled battery 14 in the following manner, in response to the results of detection performed by the voltage detection circuit 20, the current detecting resistor 16, the cell temperature sensor 17a, and the ambient temperature sensor 17b, when charging is or is not performed.

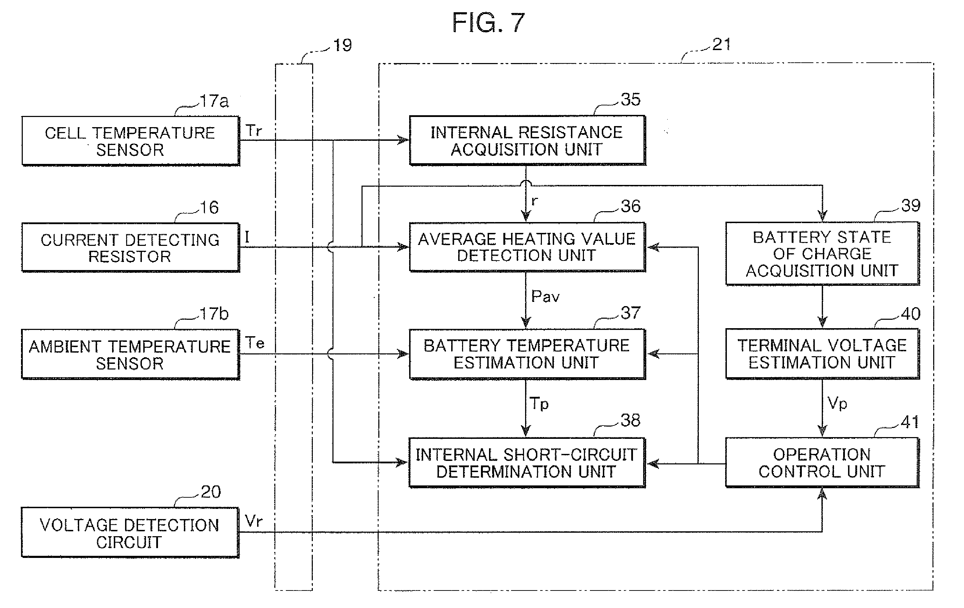

Fig. 7 shows a functional block diagram of the control determination unit 21. As will be described hereinafter, the control determination unit 21 has an internal resistance acquisition unit 35, an average heating value detection unit 36, a battery temperature estimation unit 37, an internal short-circuit determination unit 38, a battery state of charge acquisition unit 39, a terminal voltage estimation unit 40, an operation control unit 41, and an unshown memory.

The internal resistance acquisition unit 35 functions to obtain a battery internal resistance r that corresponds to a battery temperature Tr detected by the cell temperature sensor 17a. In order to realize this function, for example, the internal resistance acquisition unit 35 can store in the memory a look-up table showing a correspondence relationship between the battery temperature Tr and the battery internal resistance r, and acquire, from the look-up table, the internal resistance value r corresponding to the battery temperature Tr detected by the cell temperature sensor 17a. Alternatively, the internal resistance acquisition unit 35 may calculate the battery internal resistance r from a temperature coefficient of the internal resistance of the assembled battery 14 and the battery temperature Tr detected by the cell temperature sensor 17a.

The average heating value detection unit 36 functions to detect an average value Pav of heating values of the battery per predetermined first period ΔW1, which are generated by discharging or charging the battery. In order to realize this function, for example, the average heating value detection unit 36 calculates a heating value P of the battery a predetermined number of times on the basis of a current I detected by the current detecting resistor 16 and the internal resistance r acquired by the internal resistance acquisition unit 35 during the first period ΔW1, and obtains the average value Pav of the heating values P. The operation performed by this average heating value detection unit 36 is described hereinafter in detail.

Moreover, the battery temperature estimation unit 37 functions to obtain a battery temperature Tp estimated to be reached after a lapse of a predetermined second period ΔW2 after the average heating value detection unit 36 detects the average value Pav of the heating values, based on the average value Pav of the heating values and the ambient temperature Te detected by the ambient temperature sensor 17b. The operation performed by this battery temperature estimation unit 37 is described hereinafter in detail.

The internal short-circuit determination unit 38 functions to determine that an internal short circuit is generated when the actual battery temperature Tr after the lapse of the second period ΔW2 is equal to or greater than the sum of the estimated battery temperature Tp and a coefficient α. In other words, when an internal short circuit is generated due to the mechanisms shown in Figs. 5A to 5D, it is speculated that a current flows through the short-circuit section. Then, such an internal short circuit brings an increase in temperature of the assembled battery 14, which is unproportional to the amount of discharge or charge of the assembled battery 14. Therefore, the internal short-circuit determination unit 38 determines whether or not there is an increase in temperature of the assembled battery 14 that is unproportional to the amount of discharge or charge, based on the determination condition (Tr ≥ αTp) above, and determines the presence/absence of an internal short circuit.

The control determination unit 21 shown in Fig. 7 functions to manage a battery state of charge SOC. The battery state of charge acquisition unit 39 functions to acquire the battery state of charge SOC at the start of the first period ΔW1, thereafter update the battery state of charge SOC each time the current detecting resistor 16 detects the current I flowing through the outside of the assembled battery 14, and then obtain the battery state of charge SOC after the lapse of the first period ΔW1. The operation performed by this battery state of charge acquisition unit 39 is described hereinafter in detail.

The terminal voltage estimation unit 40 functions to obtain a terminal voltage Vp of the battery that is estimated from the battery state of charge SOC at the time of a lapse of the first period ΔW1. For example, the terminal voltage estimation unit 40 can store in the memory a look-up table showing a correspondence relationship between the battery state of charge SOC and the terminal voltage Vp, and acquire, from the look-up table, the terminal voltage Vp corresponding to the battery state of charge SOC at the time of the lapse of the first period ΔW1. The operation of this terminal voltage estimation unit 40 is described hereinafter in detail.

The voltage detection circuit 20 detects an actual terminal voltage Vr of the battery after the lapse of the first period ΔW1. The operation control unit 41 functions to operate the average heating value detection unit 36, the battery temperature estimation unit 37, and the internal short-circuit determination unit 38 only when the actual terminal voltage Vr of the battery is equal to or lower than the threshold value which is the sum of the terminal voltage Vp and a coefficient β.

In other words, at the time of charging, when the actual terminal voltage Vr of the battery is disproportionatley low to the amount of charge in spite of the flowing charging current, the operation control unit 41 determines that it is highly possible that an internal short circuit is generated, and causes the average heating value detection unit 36, the battery temperature estimation unit 37, and the internal short-circuit determination unit 38 to execute a subsequent internal short-circuit determination operation. When, on the other hand, the actual terminal voltage Vr of the battery is not disproportionately low to the amount of charge, the operation control unit 41 determines that an internal short circuit is not generated, and skips the subsequent internal short-circuit determination operation.

Moreover, at the time of discharging (non-charging), when the actual terminal voltage Vr of the battery is disproportionately low to the amount of discharge, the operation control unit 41 determines that it is highly possible that an internal short circuit is generated, and causes the average heating value detection unit 36, the battery temperature estimation unit 37, and the internal short-circuit determination unit 38 to execute the subsequent internal short-circuit determination operation. When, on the other hand, the actual terminal voltage Vr of the battery is not disproportionately low to the amount of discharge, the operation control unit 41 determines that an internal short circuit is not generated, and skips the subsequent internal short-circuit determination operation.

By allowing the operation control unit 41 to cause the average heating value detection unit 36, the battery temperature estimation unit 37 and the internal short-circuit determination unit 38 to perform the operation control, the accuracy of determining the occurrence of an internal short circuit can be improved, and the determination processing can be simplified.

In addition, the unshown memory stores the data of the above mentioned look-up tables and operation programs. The memory also has a storage area for temporarily storing various data items such as computation result data.

Each of the functions of the control determination unit 21 is realized by the CPU or storage devices (ROM, RAM) of the microcomputer.

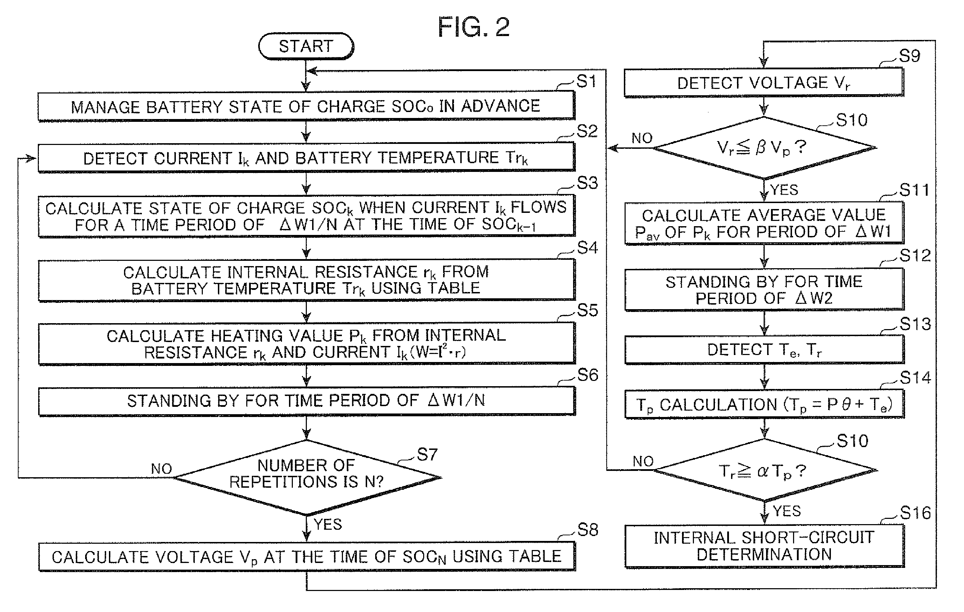

Fig. 2 is a flowchart which explains in detail the determination operation performed by the control determination unit 21. The control determination unit 21 manages a battery state of charge SOC₀ in advance in step S1. Then in step S2 the control determination unit 21 loads the results of the detection performed by the current detecting resistor 16 and the cell temperature sensors 17a through the analog/digital converter 19, and stores the results as a current I_{K} and battery temperature Tr_{K} into the memory.

Here, in the electronic device system, the charging current is detected by the current detecting resistor 16 at the time of charging of the assembled battery 14, and the discharging current is detected by the current detecting resistor 16 at the time of discharging (non-charging).

Next, in step S3, the control determination unit 21 calculates a battery state of charge SOCK of the time when the current I_{K} flows for a period of ΔW1/N, relation to a battery state of charge SOC_{K-1} managed beforehand. Here, the period ΔW1 is the predetermined first period and can be, for example, 60 seconds depending on the capacity of the battery. The value N is the number of samplings in the first period ΔW1 and can be, for example, 60 or other value that can divide out the first period ΔW1. This step S3 is executed by the battery state of charge acquisition unit 39 shown in Fig. 7.

In the next step S4, the control determination unit 21 calculates a battery internal resistance r_{K} from the battery temperature Tr_{K} stored in step S2, based on a look-up table shown in Table 1. Note that Table 1 is merely an image and does not necessarily show accurate data. This step S4 is executed by the internal resistance acquisition unit 35 shown in Fig. 7.

**[Table 1]**

| Temperature (°C) | 0 | 10 | 20 | 30 | 40 |
|---|---|---|---|---|---|
| Internal Resistance (mΩ) | 4.0 | 2.0 | 1.0 | 0.7 | 0.5 |

In the next step S5, the control determination unit 21 uses the internal resistance r_{K} calculated in step S4 and the current I_{K} stored in step S2, to calculate an instant heating value P_{K} from (I_{K})²·r_{K}. In the subsequent step S6, the control determination unit 21 stands by for the period of ΔW1/N, and thereafter determines in step S7 whether steps S1 to S6 are repeated N times or not. If the result of step S7 is NO, the control determination unit 21 increments K, returns to step S2 thereafter, and repeatedly executes steps S1 to S6.

If the result of step S7 is YES, that is, when N number of sample data items over the first period ΔW1, the process is advanced to the next step S8. Note that a battery state of charge SOC_{N} is obtained through the above-described routine after the lapse of the first period ΔW1.

Thus, in step S8 the control determination unit 21 calculates, from a look-up table shown in Table 2, the terminal voltage Vp estimated from the battery state of charge SOC_{N} at the time of the lapse of the first period ΔW1. This look-up table acquires, beforehand, data showing the correspondence relationship between the battery state of charge SOC and the terminal voltage Vp. Table 2 is also merely an image and does not necessarily show accurate data. This step S8 is executed by the terminal voltage estimation unit 40 shown in Fig. 7.

**[Table 2]**

| SOC (%) | 0 | 20 | 40 | 60 | 80 | 100 |
|---|---|---|---|---|---|---|
| Voltage (V) | 0 | 3.2 | 3.6 | 4.0 | 4.3 | 4.4 |

Subsequently, in step S9 the control determination unit 21 uses the voltage detection circuit 20 to load the actual battery voltage Vr. Furthermore, in step S10 the control determination unit 21 determines whether or not the actual battery voltage Vr is equal to or lower than a threshold voltage βVp obtained by adding an appropriate coefficient β to the terminal voltage Vp corresponding to the battery state of charge SOC_{N} obtained in step S8. A value of approximately 1.0 to 1.2 is used as the coefficient β.

When the actual battery voltage Vr is equal to or lower than the threshold voltage βVp in step S10, the control determination unit 21 determines that it is highly possible that an internal short circuit is generated. Specifically, when Vr ≤ βVp is satisfied at the time of charging, it means that the actual terminal voltage Vr of the battery is disproportionately low to the amount of charge in spite of the flowing charging current, and thus it is highly possible that an internal short circuit is generated. In addition, when Vr ≤ βVp is satisfied at the time of discharging (non-charging), it means that the actual terminal voltage Vr of the battery is disproportionately low to the amount of discharge, and thus it is highly possible that an internal short circuit is generated.

When the result of step S10 is YES, the process is advanced to step S11. This step S10 is executed by the operation control unit 41 shown in Fig. 7.

In step S11 the control determination unit 21 calculates the average value Pav of the heating values P_{K} obtained in step S5 over the first period ΔW1. These steps S5 and S11 are executed by the average heat generating detection unit 36 shown in Fig. 7.

Thereafter, in step S12 the control determination unit 21 stands by for the predetermined second period ΔW2 and moves to step S13. In step S13 the control determination unit 21 loads the ambient temperature Te detected by the ambient temperature sensor 17b and the actual battery temperature Tr detected by the cell temperature sensor 17a, through the analog/digital converter 19.

In the next step S14, the control determination unit 21 calculates, from Pavθ + Te, the battery temperature Tp that is predicted after the lapse of the second period ΔW2, when the average value of the heating values over the first period ΔW1 is Pav. Here, the value Pav is the heating value (unit: W) inside the battery as described above. Further, the value θ represents a thermal resistance (unit: °C/W) obtained when the heat of the surface of the battery is released to atmosphere, and is determined by the superficial area or specific heat of the battery, as well as by the heat dissipation structure of the battery pack, such as a fan around the battery. A value between 10 to 20, for example, is used as the value θ. As the second period ΔW2, the time required for the heat to be transmitted to the outside at the time of the occurrence of an internal short circuit is appropriated selected, the heat being generated by the short circuit, and the time is approximately, for example 60 seconds. This step S14 is executed by the battery temperature estimation unit 37 shown in Fig. 7.

Subsequently, in step S15 the control determination unit 21 determines whether or not the actual battery temperature Tr is equal to or greater than a threshold temperature αTp obtained by adding a coefficient α of approximately 1 to 1.2 to the battery temperature Tp obtained in step S14. This step S15 is executed by the internal short-circuit determination unit 38 shown in Fig. 7.

When the result of step S15 is YES, the control determination unit 21 determines that an internal short circuit is generated in the assembled battery 14 due to the mechanisms shown in Figs. 5A to 5D. Specifically, when Tr ≥ αTp is satisfied, it means that the actual battery temperature Tr is disproportionately high to the amount of charge when charging is performed, and hence it can be determined that an internal short circuit is generated. In addition, when Tr ≥ αTp is satisfied, it means that the actual battery temperature Tr is disproportionately high to the amount of discharge when discharging (non-charging) is performed, and hence it can be determined that an internal short circuit is generated.

When the result of step S15 is YES, the process is advanced to step S 16, and the control determination unit 21 carries out a protective operation of turning OFF the FETs 12, 13 shown in Fig. 1. In this case, it is preferred that the control determination unit 21 perform a warning operation by reporting the loading device 2 via the communication units 22, 32 of the occurrence of an internal short circuit or displaying it on an unshown indicator when the control determination unit 21 is provided with the indicator.

On the other hand, when the terminal voltage Vr of the battery is higher than the threshold voltage βVp in step S10, and when the actual battery temperature Tr is lower than the threshold temperature αTp in step S15, the control determination unit 21 determines that the internal short circuit is not generated, and returns to step S1 to repeat the process for each cycle of ΔW1/N.

In the configuration above, when a nonaqueous electrolyte secondary battery that has, between its negative electrode and positive electrode, a heat-resistant layer composed of a porous protective film having a resin binder and an inorganic oxide filler, or a nonaqueous electrolyte olivine-type lithium iron phosphate secondary battery with an electrode plate resistance of at least 4 Ω·cm² is used as the assembled battery 14, the cell voltage does not decrease drastically as in a normal secondary battery, even when an internal short circuit occurs. Therefore, in the conventional method, it is difficult to detect an internal short circuit from sampling values of the data, such as the voltage, current and temperature of the secondary battery.

However, in the battery internal short-circuit detecting device and method according to the present embodiment, as described above, temporal change in the voltage of the assembled battery 14 (that is, the decrease in the cell voltage and the increase in the cell temperature that are disproportionate to the amount of discharge or charge) is detected to determine that an internal short circuit is generated. Therefore, even in a battery whose voltage does not drop drastically even when an internal short circuit occurs, the internal short circuit can be detected with a high degree of accuracy.

Note that the management of the SOC in step S1, calculation of the state of charge SOCK in step S3 that is obtained when the current I_{K} flows for a time period of ΔW1/N, and comparison between the predicted battery voltage Vp and the actual voltage βVr that is performed from steps S8 to S10 may not necessarily performed and thus can be omitted. However, the accuracy of determining an internal short circuit can be further improved by carrying out these processes.

By applying the management of the battery state of charge SOC, which is normally performed, it is determined in step 10 whether or not the terminal voltage drops disproportionately to the amount of discharge or charge. Only when the terminal voltage drops, an internal short-circuit determination process (the process for determining whether battery heat is generated disproportionately to the amount of discharge or charge) after step S11 can be performed so that the determination process is omitted.

In the present invention, when detecting an internal short circuit in a nonaqueous electrolyte secondary battery with a heat-resistant layer or an olivine-type lithium iron phosphate secondary battery, which is difficult to do with the sampling values of the data such as the voltage, current and temperature of such secondary battery, an internal short circuit is detected by determining that an internal short circuit occurs when the cell voltage drops or cell temperature increases disproportionately to the amount of discharge. Thus, the present invention is suitable in a device incorporated with a battery, such as a battery pack or an uninterruptible power system that has the secondary battery configured as above.

Note that the battery internal short-circuit detecting device or method of the present embodiment can be used preferably in, but not limited, to a nonaqueous electrolyte secondary battery that has a heat-resistant layer between the negative electrode and the positive electrode, as well as in a nonaqueous electrolyte secondary battery having an electrode plate resistance of at least 4 Ω·cm². In other words, the battery internal short-circuit detecting device and method can be used preferably in a battery whose voltage does not drop rapidly even when an internal short circuit is generated.

Moreover, in the present embodiment the battery internal short-circuit detecting device is embedded in the battery pack, but the present embodiment is not limited to this pattern. Thus, the internal short-circuit detecting device may be incorporated in the loading device.

A battery internal short-circuit detecting device according to one aspect of the present invention has: a battery temperature detection unit for detecting a battery temperature Tr; an ambient temperature detection unit for detecting an ambient temperature Te; an average heating value detection unit for detecting an average value Pav of battery heating values per predetermined first period ΔW1, which are generated by discharging or charging the battery; a battery temperature estimation unit for obtaining a battery temperature Tp estimated to be reached after a lapse of a predetermined second period ΔW2 since the detection of the average value Pav of the heating values, based on the average value Pav of the heating values and the ambient temperature Te; and an internal short-circuit determination unit for determining that an internal short circuit has occurred when the actual battery temperature Tr after the lapse of the second period ΔW2 is equal to or greater than the sum of the estimated battery temperature Tp and a predetermined coefficient α.

According to the foregoing configuration, an internal short circuit can be detected reliably even in a battery whose voltage does not drop rapidly even when an internal short is generated, as will be described hereinafter.

In other words, when the temperature of the battery does not increase proportionately to the amount of charge or discharge, it is speculated that an internal short circuit is generated by the above mentioned mechanisms and that a discharging current flows through the short-circuit section in the battery. Thus, whether an internal short circuit has occurred or not is determined by detecting the flow of the discharging current.

Specifically, the battery is discharged or charged for the predetermined first period ΔW1, and the average heating value detection unit detects the average value Pav of the heating values of the first period ΔW1. Moreover, the ambient temperature detection unit detects the ambient temperature Te for deciding the radiation property of the heat generated in the battery, when or after the first period ΔW1 elapses. Then, the battery temperature estimation unit obtains the battery temperature Tp that is estimated to be reached after a lapse of the predetermined second period ΔW2 since the detection of the average value Pav of the heating values, based on the average value Pav of the heating values and the ambient temperature Te. Further, the internal short-circuit determination unit determines that an internal short circuit has occurred, when the actual battery temperature Tr after the lapse of the second period ΔW2 is equal to or greater than the sum of the estimated battery temperature Tp and the coefficient α.

As a result, an internal short circuit can be detected with a high degree of accuracy, even in a battery whose voltage does not drop drastically even when an internal short circuit is generated.

It is preferred that the foregoing configuration further include a current detection unit for detecting a current I flowing to the battery, and an internal resistance acquisition unit for obtaining a battery internal resistance r corresponding to the battery temperature Tr, and that the average heating value detection unit calculate the heating value P of the battery a predetermined number of times based on the current I and the internal resistance r during the first period ΔW1 and obtain the average value of the heating values P as the above mentioned Pav.

According to the foregoing configuration, during the first period ΔW1, the current detection unit detects the current I, and the battery temperature detection unit detects the battery temperature Tr, when obtaining whether or not the temperature of the secondary battery increases disproportionately to the amount of discharge or charge. Furthermore, the internal resistance r corresponding to the detected battery temperature Tr is obtained by the internal resistance acquisition unit. Thereafter, the average heating value detection unit calculates the instant heating value P a predetermined number of times based on the current I and the internal resistance r during the first period ΔW1, and obtains the average value Pav of the heating values P.

Because the average value Pav of the heating values is obtained from the relatively accurate heating values resulting from the current flowing to the battery, the internal short circuit can be detected accurately.

It is preferred that the configuration mentioned above have: a battery state of charge acquisition unit for acquiring the battery state of charge SOC at the start of the first period ΔW1, thereafter updating the battery state of charge SOC each time the current detection unit detects the current I, and obtaining the battery state of charge SOC at the time of the lapse of the first period ΔW1; a terminal voltage estimation unit for obtaining a battery terminal voltage Vp estimated from the battery state of charge SOC at the time of the lapse of the first period ΔW1; a terminal voltage detection unit for detecting an actual battery terminal voltage Vr at the time of the lapse of the first period ΔW1; and an operation control unit for operating the average heating value detection unit, the battery temperature estimation unit and the internal short-circuit determination unit, only when the actual battery terminal voltage Vr is equal to or lower than a threshold value obtained by adding a predetermined coefficient β to the terminal voltage Vp.

According to the foregoing configuration, by applying the management of the battery state of charge SOC, which is normally performed, it is determined whether or not the terminal voltage drops disproportionately to the amount of discharge or charge. Only when the terminal voltage drops, the operations of the average heating value detection unit, the battery temperature estimation unit and the internal short-circuit determination unit (that is, the process for determining whether battery heat is generated disproportionately to the amount of discharge or charge) can be executed. Accordingly, the accuracy of determining the occurrence of an internal short circuit can be improved, and the determination processing can be simplified.

According to the foregoing configuration, for example, a nonaqueous electrolyte secondary battery that has a heat-resistant layer between the negative electrode and positive electrode of the battery, or a nonaqueous electrolyte secondary battery with an electrode plate resistance of at least 4 Ω·cm² can be used as the battery.

A battery pack according to another aspect of the present invention has a battery and the battery internal short-circuit detecting device having any of the foregoing configurations of the present invention.

An electronic device system according to yet another aspect of the present invention has a battery, a loading device supplied with power from the battery, and the battery internal short-circuit detecting device having any of the foregoing configurations of the present invention.

According to the battery pack and the electronic device system of the present invention, the same effects as achieved from the configuration of each of the internal short-circuit detecting devices of the present invention described above can be accomplished.

A battery internal short-circuit detecting method according to yet another aspect of the present invention has: an average heating value detection step of detecting an average value Pav of battery heating values per predetermined first period ΔW1, which are generated by discharging or charging a battery; a battery temperature estimation step of obtaining a battery temperature Tp estimated to be reached after a lapse of a predetermined second period ΔW2 since the detection of the average value Pav of the heating values, based on the average value Pav of the heating values and the ambient temperature Te; a step of detecting an actual battery temperature Tr after the lapse of the second period ΔW2; and an internal short-circuit determination step of determining that an internal short circuit has occurred when the actual battery temperature Tr after the lapse of the second period ΔW2 is equal to or greater than the sum of the estimated battery temperature Tp and a predetermined coefficient α.

In the internal short-circuit detecting method, it is preferred that the average heating value detection step have a step of obtaining the current I flowing to the battery, a step of obtaining the battery internal resistance r corresponding to the battery temperature Tr, and a step of calculating the heating value P of the battery a predetermined number of times based on the current I and the internal resistance r during the first period ΔW1, to obtain the average value Pav of the heat generating values P.

It is preferred that the internal short-circuit detecting method further have: a step of acquiring the battery state of charge SOC at the start of the first period ΔW1; a step of updating the battery state of charge SOC each time the current detection unit detects the current I, after the step of acquiring the battery state of charge SOC, and then obtaining the battery state of charge SOC at the time of the lapse of the first period ΔW1; a step of obtaining a battery terminal voltage Vp estimated from the battery state of charge SOC obtained at the time of the lapse of first period ΔW1; a step of detecting the actual battery terminal voltage Vr at the time of the lapse of the first period ΔW1; and a step of starting the average heating value detection step, only when the actual battery terminal voltage Vr is equal to or lower than a threshold value obtained by adding a predetermined coefficient β to the terminal voltage Vp.

In the internal short-circuit detecting method, a nonaqueous electrolyte secondary battery that has a heat-resistant layer between the negative electrode and the positive electrode of the battery, or a nonaqueous electrolyte secondary battery with an electrode plate resistance of at least 4 Ω·cm² can be used as the battery.

According to each of the foregoing internal short-circuit detecting methods, the same effects as achieved from the configuration of each of the internal short-circuit detecting devices of the present invention described above can be accomplished.

The present invention can provide a battery internal short-circuit detecting device, a method, a battery pack and an electronic device system capable of reliably detecting an internal short circuit in a battery whose voltage does not drop rapidly even when an internal short circuit is generated,.

### Industrial Applicability

The present invention can be utilized in a charging system that is used as electronic devices such as a portable personal computer, a digital camera, an uninterruptible power system and a cellular phone, as well as in a battery-mounted device such as an electric vehicle and a hybrid car. The present invention can also be utilized preferably in a battery pack used as the power source of such battery-mounted devices, and in a charging device for charging such a battery pack.

## Claims

1. A battery internal short-circuit detecting device, comprising:
a battery temperature detection unit for detecting a battery temperature Tr;
an ambient temperature detection unit for detecting an ambient temperature Te;
an average heating value detection unit for detecting an average value Pav of battery heating values per predetermined first period ΔW1, which are generated by discharging or charging the battery;
a battery temperature estimation unit for obtaining a battery temperature Tp estimated to be reached after a lapse of a predetermined second period ΔW2 since the detection of the average value Pav of the heating values, based on the average value Pav of the heating values and the ambient temperature Te; and
an internal short-circuit determination unit for determining that an internal short circuit has occurred when an actual battery temperature Tr after the lapse of the second period ΔW2 is equal to or greater than the sum of the estimated battery temperature Tp and a predetermined coefficient α.

2. The battery internal short-circuit detecting device according to claim 1, further comprising:
a current detection unit for detecting a current I flowing to the battery; and
an internal resistance acquisition unit for obtaining a battery internal resistance r corresponding to the battery temperature Tr,
wherein the average heating value detection unit calculates a heating value P of the battery a predetermined number of times based on the current I and the internal resistance r during the first period ΔW1, and obtains the average value of the heating values P as the Pav.

3. The battery internal short-circuit detecting device according to claim 2, further comprising:
a battery state of charge acquisition unit for acquiring the battery state of charge SOC at the start of the first period ΔW1, thereafter updating the battery state of charge SOC each time the current detection unit detects the current I, and obtaining the battery state of charge SOC at the time of the lapse of the first period ΔW1;
a terminal voltage estimation unit for obtaining a battery terminal voltage Vp estimated from the battery state of charge SOC obtained at the time of the lapse of the first period ΔW1;
a terminal voltage detection unit for detecting an actual battery terminal voltage Vr at the time of the lapse of the first period ΔW1; and
an operation control unit for operating the average heating value detection unit, the battery temperature estimation unit and the internal short-circuit determination unit, only when the actual battery terminal voltage Vr is equal to or lower than a threshold value obtained by adding a predetermined coefficient β to the terminal voltage Vp.

4. The battery internal short-circuit detecting device according to any one of claims 1 to 3, wherein the battery is a nonaqueous electrolyte secondary battery that has a heat-resistant layer between a negative electrode and a positive electrode of the battery, or a nonaqueous electrolyte secondary battery with an electrode plate resistance of at least 4 Ω·cm².

5. A battery pack, comprising:
a battery; and
the battery internal short-circuit detecting device described in any one of claims 1 to 4.

6. An electronic device system, comprising:
a battery;
a loading device supplied with power from the battery; and
the battery internal short-circuit detecting device described in any one of claims 1 to 4.

7. A battery internal short-circuit detecting method, comprising:
a step of detecting a battery temperature Tr;
a step of detecting an ambient temperature Te;
an average heating value detection step of detecting an average value Pav of battery heating values per predetermined first period ΔW1, which are generated by discharging or charging a battery;
a battery temperature estimation step of obtaining a battery temperature Tp estimated to be reached after a lapse of a predetermined second period ΔW2 since the detection of the average value Pav of the heating values, based on the average value Pav of the heating values and the ambient temperature Te;
a step of detecting an actual battery temperature Tr after the lapse of the second period ΔW2; and
an internal short-circuit determination step of determining that an internal short circuit has occurred when the actual battery temperature Tr after the lapse of the second period ΔW2 is equal to or greater than the sum of the estimated battery temperature Tp and a predetermined coefficient α.

8. The battery internal short-circuit detecting method according to claim 7, wherein the average heating value detection step has a step of obtaining a current I flowing to the battery, a step of obtaining a battery internal resistance r corresponding to the battery temperature Tr, and a step of calculating a heating value P of the battery a predetermined number of times based on the current I and the internal resistance r during the first period ΔW1, to obtain the average value of the heating values P as the Pav.

9. The battery internal short-circuit detecting method according to claim 8, further comprising:
a step of acquiring the battery state of charge SOC at the start of the first period ΔW1;
a step of updating the battery state of charge SOC each time the current detection unit detects the current I, after the step of acquiring the battery state of charge SOC, and then obtaining the battery state of charge SOC at the time of the lapse of the first period ΔW1;
a step of obtaining a battery terminal voltage Vp estimated from the battery state of charge SOC obtained at the time of the lapse of first period ΔW1;
a step of detecting an actual battery terminal voltage Vr at the time of the lapse of the first period ΔW1; and
a step of starting the average heating value detection step, only when the actual battery terminal voltage Vr is equal to or lower than a threshold value obtained by adding a predetermined coefficient β to the terminal voltage Vp.

10. The battery internal short-circuit detecting method according to any one of claims 7 to 9, wherein the battery is a nonaqueous electrolyte secondary battery that has a heat-resistant layer between a negative electrode and a positive electrode of the battery, or a nonaqueous electrolyte secondary battery with an electrode plate resistance of at least 4 Ω·cm².
